Europäisches Patentamt

European Patent Office

Office européen des brevets

(11) Publication number: **0 349 824**
A2

# EUROPEAN PATENT APPLICATION

(21) Application number: 89111186.6

(22) Date of filing: 20.06.89

(51) Int. Cl.⁴: **H03K 19/017**

(30) Priority: 30.06.88 JP 163607/88

(43) Date of publication of application:
10.01.90 Bulletin 90/02

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Ueno, Kouji
139-4-1211, Ohmaru
Inagi-shi Tokyo, 206(JP)
Inventor: Yamaguchi, Daisuke
2-19-3-106, Suge Tama-ku
Kawasaki-shi Kanagawa, 214(JP)
Inventor: Matsuzaki, Yasurou
3-4-13, Sekido
Tama-shi Tokyo 206(JP)

(74) Representative: Seeger, Wolfgang, Dipl.-Phys.
Georg-Hager-Strasse 40
D-8000 München 70(DE)

(54) Integrated circuit having level converting circuit.

(57) An integrated circuit for converting a first signal
having an emitter coupled logic level into a second
signal having a transistor-transistor logic level, com-
prises an ECL circuit (10, 20, 20a) including emitter
coupled first and second transistors (T10, T20a-
T20n; T11, T21), where the first transistor has a base
for receiving the first signal, a reference voltage
applying part (13, 25, 25a, 32) for applying a reference voltage to a base of the second transistor, a
Schottky barrier diode (14, 26) having an anode
coupled to the base of the second transistor and a
cathode coupled to a collector of the second transis-
tor, and a TTL circuit (12, 28, 30) for outputting the
second signal in response to a signal received from
the collector of the second transistor.

# INTEGRATED CIRCUIT HAVING LEVEL CONVERTING CIRCUIT

## BACKGROUND OF THE INVENTION

The present invention generally relates to integrated circuits, and more particularly to an integrated circuit which has a level converting circuit for converting a logic signal having an emitter coupled logic (ECL) into a logic signal having a transistor-transistor logic (TTL) level.

Generally, in digital circuits, a so-called standard logic is determined to cope with the user's needs. The standard logic includes an ECL, TTL, complementary metal oxide semiconductor (CMOS) and the like. For example, the ECL is used for carrying out a high-speed operation in a central processing unit (CPU) or the like by utilizing the superior high-speed signal transmission characteristic of the ECL. On the other hand, the TTL is used for making various logic circuits which carry out error-free operations by utilizing a superior noise margin of the TTL.

On the other hand, there are semiconductor chips on which different standard logics coexist. In such a semiconductor chip, it is essential for the signal transmission to provide a level converting circuit for converting a signal having the ECL level into a signal having the TTL logic, for example. In particular, the level converting circuit for converting the signal having the ECL level into the signal having the TTL logic must not deteriorate the high-speed signal transmission characteristic of the ECL nor the stable operation characteristic of the TTL.

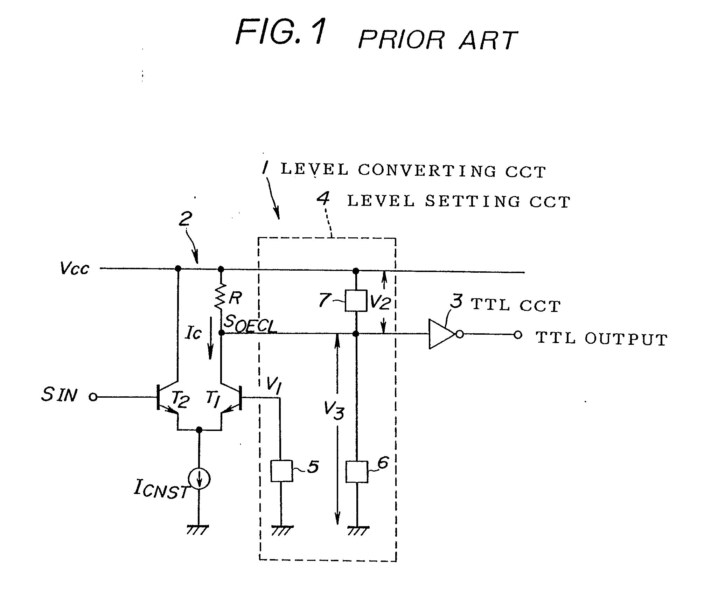

FIG.1 shows an example of a conventional ECL-to-TTL level converting circuit. In FIG.1, a level converting circuit 1 has an ECL circuit 2, a TTL circuit 3, and a level setting circuit 4 which is provided between the ECL circuit 2 and the TTL circuit 3. The level setting circuit 4 is provided with a constant power source part 5 for generating a constant voltage $V_1$, a low potential setting part 6 for setting a low-level potential of an output logic of the ECL circuit 2, and a high potential setting part 7 for setting a high-level potential of the output logic of the ECL circuit 2. Generally, the ECL circuit 2 carries out a high-speed operation when a transistor T1 is ON and is in a non-saturation state, by always maintaining a relationship that a base potential is smaller than a collector potential of the transistor T1. In addition to the transistor T1, the ECL circuit 2 is also provided with a load resistor R, a transistor T2 and a constant current source $I_{CNST}$.

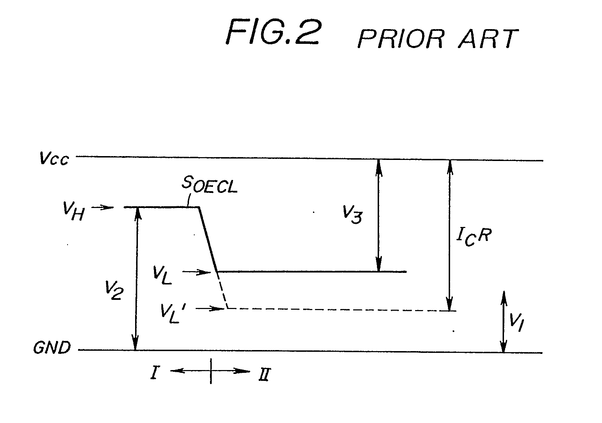

FIG.2 shows a signal level of an output signal $S_{OECL}$ of the ECL circuit 2. In FIG.2, during a time I in which an input signal $S_{IN}$ applied to a base of the transistor T2 of the ECL circuit 2 has a high level, the output signal $S_{OECL}$ has a potential $V_H$ ( = GND + $V_2$) which is set by the high potential setting part 7. During a time II in which the input signal $S_{IN}$ has a low level, the output signal $S_{OECL}$ has a potential $V_L$ ( = Vcc-$V_3$) which is set by the low potential setting part 6, where GND denotes a ground potential. During these times I and II, the transistor T1 is reverse biased between the base and collector thereof. When it is assumed for the sake of convenience that the low potential setting part 6 is removed from the level converting circuit 1, the level of the output signal $S_{OECL}$ becomes a potential $V_L'$ during the time II. This potential $V_L'$ is equal to a potential which is obtained by subtracting from a constant power source voltage Vcc a voltage drop $I_CR$ across the load resistor R caused by a collector current $I_C$ which flows through the transistor T1 of the ECL circuit 2 which is ON. In other words, $V_L' = Vcc-I_CR$. For this reason, when the voltage drop $I_CR$ is large, the collector potential of the transistor T1 may become smaller than a base potential $V_1$ of the transistor T1. In such a case where the transistor T1 is forward biased, the transistor T1 is in a saturation state and prevents the high-speed operation of the ECL circuit 2. However, the conventional level converting circuit 1 uses the low potential setting part 6 to restrict the potential $V_L$ so that the potential $V_L$ does not become less than or equal to the base potential $V_1$, and it is thus possible to maintain the transistor T1 in the non-saturation state and ensure the high-speed operation. It is not necessary to provide the low potential setting part 6 when a relation $V_1 \leq Vcc-I_CR$ stands.

But the conventional level converting circuit 1 maintains the non-saturation operation of the ECL circuit 2 based on the relationship of the potentials $V_1$ and $V_L$ which are respectively generated in the constant voltage source part 5 and the low potential setting part 6, and the high-speed operation is enabled thereby. As a result, the operation of the ECL circuit 2 may easily change to the saturation operation when the base potential $V_1$ rises due to a noise or the like and when the potential $V_L$ falls due to a noise or the like. In other words, it is difficult in general to appropriately maintain the relationship of the potentials $V_1$ and $V_L$ which are generated by the respective constant power source part 5 and the low potential setting part 6 which are mutually independent, and the conventional level converting circuit 1 suffers a problem in that it is difficult to stabilize the circuit operation.

It is conceivable to make a potential difference between the potentials $V_1$ and $V_L$ relatively large so as to eliminate the above described problem. But in this case, the logic amplitude of the input signal to the TTL circuit 3 becomes small and there is a problem in that the noise margin of the TTL circuit 3 becomes deteriorated.

## SUMMARY OF THE INVENTION

Accordingly, it is a general object of the present invention to provide a novel and useful integrated circuit in which the problems described above are eliminated.

Another and more specific object of the present invention to provide an integrated circuit for converting a first signal having an emitter coupled logic level into a second signal having a transistor-transistor logic level, comprises a first power source for supplying a first power source voltage, a second power source for supplying a second power source voltage, an emitter coupled logic circuit including first and second transistors having emitters thereof coupled to each other, a load resistor coupled between the first power source and a collector of the second transistor, and a constant current source coupled between the second power source and the emitters of the first and second transistors, where the first transistor has a base for receiving the first signal and a collector coupled to the first power source, reference voltage applying means for applying a reference voltage to a base of the second transistor, where the reference voltage applying means is coupled to the second power source, a Schottky barrier diode having an anode coupled to the base of the second transistor and a cathode coupled to a collector of the second transistor, and a transistor-transistor logic circuit for outputting the second signal in response to a signal received from the collector of the second transistor. According to the integrated circuit of the present invention, it is possible to avoid accumulation of minority carriers in one of the first and second transistors which operates in a saturation region, and a high-speed operation can be carried out although the transistor operates in the saturation region. For this reason, it is only necessary to consider the output signal amplitude when selecting the load resistance of the emitter coupled logic circuit, and it is possible to obtain a sufficiently large input signal logic amplitude for the transistor-transistor logic circuit.

Other objects and further features of the present invention will be apparent from the following detailed description when read in conjunction with the accompanying drawings.

## BRIEF DESCRIPTION OF THE DRAWINGS

FIG.1 is a circuit diagram showing an example of a conventional level converting circuit;

FIG.2 shows a signal level of an output signal of an ECL circuit shown in FIG.1;

FIG.3 is a circuit diagram showing a first embodiment of an integrated circuit according to the present invention;

FIG.4 is a circuit diagram showing a second embodiment of the integrated circuit according to the present invention;

FIG.5 shows a signal level of an output signal of an ECL circuit shown in FIG.4;

FIG.6 is a circuit diagram showing a third embodiment of the integrated circuit according to the present invention; and

FIG.7 shows a signal level of an output signal of an ECL circuit shown in FIG.6.

## DESCRIPTION OF THE PREFERRED EMBODIMENTS

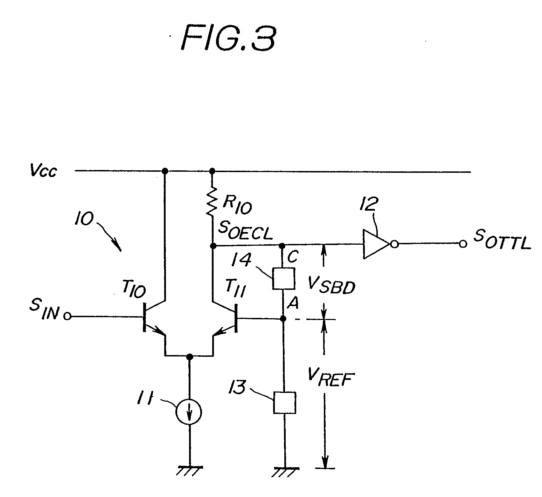

FIG.3 shows a first embodiment of an integrated circuit according to the present invention. In FIG.3, an ECL circuit 10 has transistors T10 and T11, a constant current source 11, and a load resistor R10. A TTL circuit 12 is connected to a collector of the transistor T11 of the ECL circuit 10. A reference voltage applying part 13 applies a reference voltage $V_{REF}$ to a base of the transistor T11 of the ECL circuit 10. A Schottky barrier diode 14 has an anode A connected to the base of the transistor T11 and a cathode C connected to a collector of the transistor T11. In FIG.3, $S_{IN}$ denotes a input signal which has an ECL level and is applied to a base of the transistor T10 of the ECL circuit 10, $S_{OECL}$ denotes an output signal of the ECL circuit 10, $S_{OTTL}$ denotes an output signal of the TTL circuit 12, $V_{SBD}$ denotes a forward voltage of the Schottky barrier diode 14, and Vcc denotes a constant power source voltage.

One of the transistors T10 and T11 turns ON depending on the relationship between the levels of the voltages $S_{IN}$ and $V_{REF}$. The transistor T11 is OFF when the transistor T10 is ON, and in this state, a collector voltage of the transistor T11, that is, the output signal $S_{OECL}$ has a high level which is approximately the power source voltage Vcc. This high level will hereinafter be referred to as $S_{OECL}$-(H). On the other hand, when the transistor T11 is ON, the output signal $S_{OECL}$ is clamped at a low level which is $(V_{REF}-V_{SBD})$. This low level will hereinafter be referred to as $S_{OECL}(L)$.

When it is assumed that $S_{OECL}(L) > V_{REF}$, a base-collector diode of the transistor T11 is reverse biased and the transistor T11 operates in the non-saturation region which is preferable from the point of view of realizing a high-speed operation. But on the other hand, a logic amplitude described by a level difference between $S_{OECL}(L)$ and $S_{OECL}(H)$ is small and a noise margin viewed from the side of the TTL circuit 12 is insufficient. Hence, in this embodiment, $S_{OECL}(L)$ is set to $(V_{REF}-V_{SBD})$. In other words, the base-collector diode of the transistor T11 which is ON is forward biased by the forward voltage $V_{SBD}$ of the Schottky barrier diode 14 so that the transistor T11 operates in the saturation region.

The Schottky barrier diode 14 has a structure in which a metal layer is formed on an n-type silicon layer which is doped to a low density, and electrons injected from the n-type silicon layer become majority carriers in the metal layer so that no recombination occurs. For this reason, the Schottky barrier diode 14 turns ON/OFF at a high speed and the forward voltage drop thereof is suppressed to a low value. Accordingly, the Schottky barrier diode 14 is connected between the base and collector of the transistor T11, and the forward current which is to flow through the base-collector diode of the transistor T11 which is ON flows through the Schottky barrier diode 14 and minority carriers are no longer accumulated in the base region nor the collector region of the transistor T11. That is, even when the transistor T11 is operated in the saturation region by setting $S_{OECL}(L)$ smaller than $V_{REF}$, the high-speed operation of the transistor T11 is not affected because there is no accumulation of the minority carriers. As a result, it is possible to provide a margin corresponding to the forward voltage $V_{SBD}$ between $S_{OECL}(L)$ and $S_{OECL}(H)$, and a sufficiently large logic amplitude is obtainable. The voltages $V_{REF}$ and $V_{SBD}$ are both formed with reference to a common ground potential, and even when a noise or the like mixes into the ground potential, the circuit operation is unaffected because both the voltages $V_{REF}$ and $V_{SBD}$ undergo a change in the same direction by the same quantity.

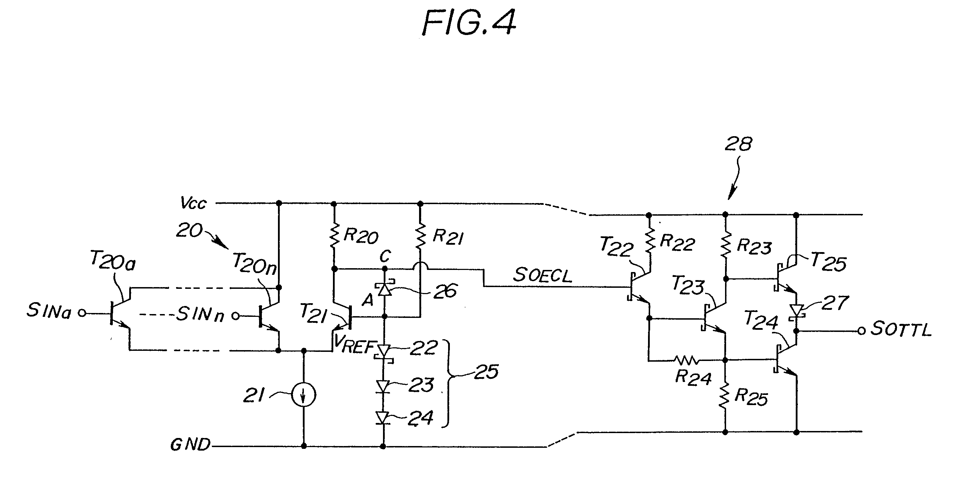

FIG.4 shows a second embodiment of the integrated circuit according to the present invention. In FIG.4, an ECL circuit 20 has a plurality of emitter-coupled transistors T20a through T20n which constitute OR circuits, an output transistor T21, a constant current source 21 for the transistors T20a through T20n and T21, and a load resistor R20 for the transistor T21. A diode group 25 made up of a Schottky barrier diode 22 and two pn junction diodes 23 and 24 which are coupled in series is connected between a base of the transistor T21 and a ground potential GND. A bias current is supplied to the diode group 25 through a bias resistor R21 which is connected to a power source voltage Vcc. The diode group 25 generates a constant reference voltage $V_{REF}$ and supplies this reference voltage $V_{REF}$ to the base of the transistor T21. Accordingly, the diode group 25 functions as the reference voltage applying part 13 shown in FIG.3. In addition, a Schottky barrier diode 26 is connected between the base and collector of the transistor T21. An anode A and a cathode C of the Schottky barrier diode 26 are respectively connected to the base and collector of the transistor T21. In other words, a forward direction of the base-collector diode of the transistor T21 and a forward direction of the Schottky barrier diode 26 are the same.

On the other hand, a TTL circuit 28 has four Schottky transistors T22 through T25, four resistors R22 through R25, and a Schottky barrier diode 27. The logic level at the input side of the TTL circuit 28 is clamped to a high level at a forward voltage corresponding to three stages of base-emitter diodes of the transistors T22 through T24. In FIG.4, $S_{INa}$ through $S_{INn}$ denote input signals.

When at least one of the input signals $S_{INa}$ through $S_{INn}$ exceeds the reference voltage $V_{REF}$, $S_{OECL}(H)$ is clamped to the high level amounting to three stages of the transistors T22 through T24 of the TTL circuit 28. In addition, when all of the input signals $S_{INa}$ through $S_{INn}$ are smaller than the reference voltage $V_{REF}$, the level of $S_{OECL}(L)$ becomes lower than the reference voltage $V_{REF}$ by the forward voltage of the Schottky barrier diode 26 and the transistor T21 operates in the saturation region. But in this case, a current flows from the base to the collector of the transistor T21 through Schottky barrier diode 26, and no minority carriers are accumulated within the transistor T21. Hence, the high-speed operation is unaffected although the transistor T21 operates in the saturation region.

Furthermore, because it is possible to make the transistor T21 operate in the saturation region, the resistance of the load resistor R20 may be selected by primarily considering the logic amplitude of the output signal $S_{OECL}$ and it is possible to obtain a sufficiently large logic amplitude. The logic amplitude of the output signal $S_{OECL}$ which is obtained in this manner is limited by $S_{OECL}(H)$ and $S_{OECL}(L)$.

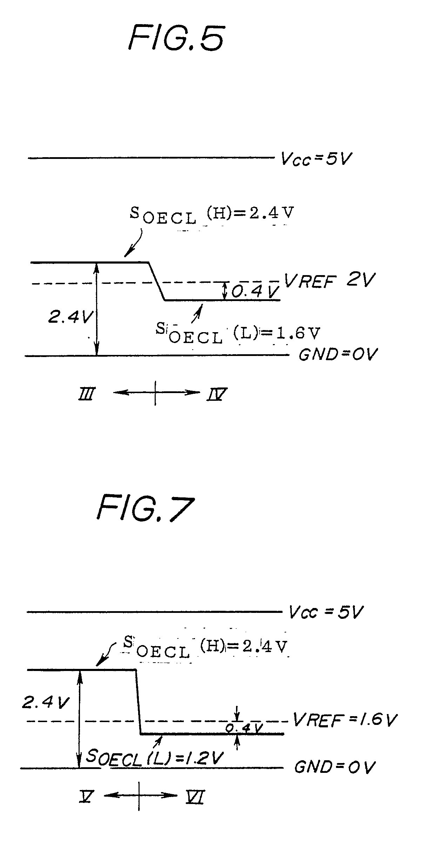

FIG.5 shows a signal level of the output signal $S_{OECL}$ of the ECL circuit 20 shown in FIG.4. In this case, the resistors R20 and R21 respectively have resistances of 8 kΩ and 6 kΩ, and the constant current source 21 generates a current of 1 mA. In addition, the power source voltages Vcc and GND respectively are 5 V and 0 V. The forward voltage of the Schottky barrier diode 26 is 0.4 V, and the reference voltage $V_{REF}$ is 2.0 V. Hence, during a time III in which the input signal $S_{INa}$ applied to the base of the transistor T20a has a high level, for example, the output signal $S_{OECL}$ is 2.4 V. During a time IV in which the input signal $S_{INa}$ has a low level, the output signal $S_{OECL}$ is 1.6 V. In other words, $S_{OECL}(H)$ is 2.4 V and $S_{OECL}(L)$ is 1.6 V, and $S_{OECL}(H)$ is determined by base-emitter voltages of the transistors T22, T23 and T24.

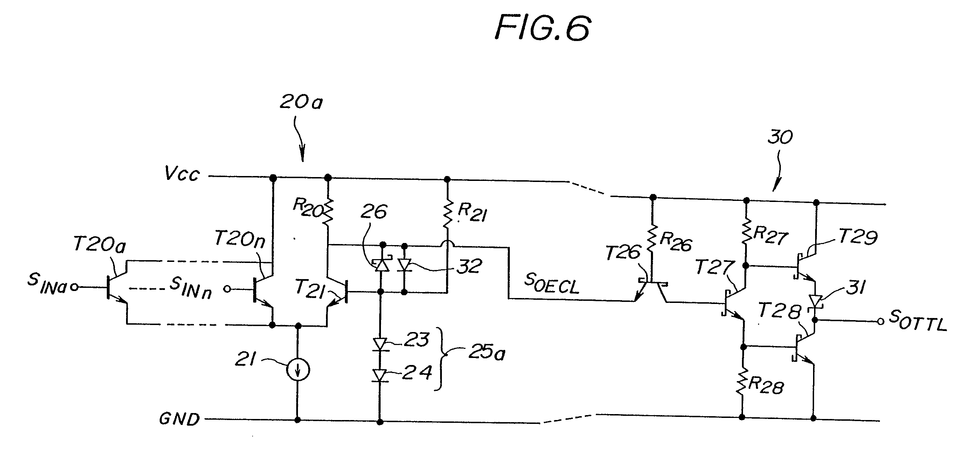

FIG.6 shows a third embodiment of the integrated circuit according to the present invention. In FIG.6, those parts which are substantially the same as those corresponding parts in FIG.4 are designated by the same reference numerals, and a description thereof will be omitted. In FIG.6, a TTL circuit 30 has four Schottky transistors T26 through T29, three resistors R26 through R28, and a Schottky barrier diode 31. The TTL circuit 30 does not have a function of clamping the high level. In this embodiment, a pn junction diode 32 is coupled in a reverse direction and in parallel to the Schottky barrier diode 26 of an ECL circuit 20a. Although only two pn junction diodes 23 and 24 are used in a diode group 25a, it is possible to add the Schottky barrier diode 22 similarly to the second embodiment shown in FIG.4.

According to this third embodiment, it is possible to obtain effects similar to those obtainable in the second embodiment. In addition, the level of $S_{OECL}(H)$ is clamped at a potential corresponding to three stages of the forward voltages of the pn junction diodes 23, 24 and 32.

FIG.7 shows a signal level of the output signal $S_{OECL}$ of the ECL circuit 20a shown in FIG.6. In this case, the resistors R20 and R21 respectively have resistances of 8 k$\Omega$ and 6k$\Omega$, and the constant current source 21 generates a current of 1 mA. In addition, the power source voltages Vcc and GND respectively are 5 V and 0 V. The forward voltage of the Schottky barrier diode 26 is 0.4 V, and the reference voltage $V_{REF}$ is 1.6 V. Hence, during a time V in which the input signal $S_{INa}$ applied to the base of the transistor T20a has a high level, for example, the output signal $S_{OECL}$ is 2.4 V. During a time VI in which the input signal $S_{INa}$ has a low level, the output signal $S_{OECL}$ is 1.2 V. In other words, $S_{OECL}(H)$ is 2.4 V and $S_{OECL}(L)$ is 1.2 V, and $S_{OECL}(H)$ is determined by the forward voltages of the pn junction diodes 32, 23 and 24.

Further, the present invention is not limited to these embodiments, but various variations and modifications may be made without departing from the scope of the present invention.

## Claims

1. An integrated circuit for converting a first signal having an emitter coupled logic level into a second signal having a transistor-transistor logic level, said emitter coupled logic level describing high and low logic levels for use within a circuit portion employing the emitter coupled logic, said transistor-transistor logic level describing high and low logic levels for use within a circuit portion employing the transistor-transistor logic, said integrated circuit comprising a first power source (Vcc) for supplying a first power source voltage, a second power source (GND) for supplying a second power source voltage, an emitter coupled logic circuit (10, 20, 20a) including first and second transistors (T10, T20a-T20n; T11, T21) having emitters thereof coupled to each other, a load resistor (R10, R20) coupled between said first power source and a collector of said second transistor, and a constant current source (11, 21) coupled between said second power source and the emitters of said first and second transistors, said first transistor having a base for receiving the first signal and a collector operatively coupled to said first power source, and a transistor-transistor logic circuit (12, 28, 30) coupled to an output side of said emitter coupled logic circuit, characterized in that there are provided: reference voltage applying means (13, 25, 25a, 32) for applying a reference voltage to a base of said second transistor, said reference voltage applying means being coupled to said second power source; and a Schottky barrier diode (14, 26) having an anode coupled to the base of said second transistor and a cathode coupled to a collector of said second transistor, and that said transistor- transistor logic circuit (12, 28, 30) outputs the second signal in response to a signal received from the collector of said second transistor.

2. The integrated circuit as claimed in claim 1, characterized in that one of said first and second transistors (T10, T20a-T20n; T11, T21) turns ON depending on a relationship of levels of the first signal and the reference voltage.

3. The integrated circuit as claimed in claim 2, characterized in that the signal received from the collector of said second transistor (T11, T21) has a first potential which is greater than the reference voltage and less than or equal to said first power source voltage when said first transistor (T10, T20a-T20n) is ON and said second transistor is OFF and has a second potential which is a forward voltage of said Schottky barrier diode (14, 26) smaller than the reference voltage.

4. The integrated circuit as claimed in any of claims 1 to 3, characterized in that a base-collector diode of said second transistor (T11, T21) in an ON state is forward biased by a forward voltage of said Schottky barrier diode (14, 26) and operates in a saturation region.

5. The integrated circuit as claimed in any of claims 1 to 4, characterized in that said transistor-transistor logic circuit (12, 28, 30) is coupled between said first and second power sources (Vcc, GND).

6. The integrated circuit as claimed in any of claims 1 to 5, characterized in that there are further provided one or a plurality of third transistors (T20a-T20n) having emitters thereof coupled to the emitters of said first and second transistors (T10, T20a-T20n; T11, T21), collectors thereof coupled to said first power source (Vcc) and bases thereof supplied with third signals having the emitter coupled logic level.

7. The integrated circuit as claimed in any of claims 1 to 6, characterized in that there is further provided a resistor (R21) coupled between said first power source (Vcc) and the anode of said Schottky barrier diode (14, 26).

8. The integrated circuit as claimed in any of claims 1 to 7, characterized in that said reference voltage applying means (13, 25, 25a, 32) comprises a group of diodes (22-24) coupled in series between said second power source (GND) and the anode of said Schottky barrier diode (14, 26).

9. The integrated circuit as claimed in claim 8, characterized in that said group of diodes (22-24) includes a Schottky barrier diode (22).

10. The integrated circuit as claimed in claim 8, characterized in that the signal received from the collector of said second transistor (T11, T21), has a first potential which is greater than the reference voltage and less than or equal to said first power source voltage when said first transistor (T10, T20a-T20n) is ON and said second transistor is OFF and has a second potential which is a forward voltage of said Schottky barrier diode (14, 26) smaller than the reference voltage, said first potential being determined by a sum of forward voltages of said group of diodes (22-24).

11. The integrated circuit as claimed in claim 8, characterized in that there is further provided a predetermined diode (32) having an anode coupled to the cathode of said Schottky barrier diode (14, 26) and a cathode coupled to the anode of said Schottky barrier diode.

12. The integrated circuit as claimed in claim 11, characterized in that the signal received from the collector of said second transistor (T11, T21) has a first potential which is greater than the reference voltage and less than or equal to said first power source voltage when said first transistor (T10, T20a-T20n) is ON and said second transistor is OFF and has a second potential which is a forward voltage of said Schottky barrier diode (14, 26) smaller than the reference voltage, said first potential being determined by a sum of forward voltages of said predetermined diode and said group of diodes (22-24).

13. The integrated circuit as claimed in any of claims 1 to 12, characterized in that said first power source voltage is a positive voltage and said second power source voltage is a zero voltage.

EP 0 349 824 A2

# FIG.1  PRIOR ART

1 LEVEL CONVERTING CCT

4 LEVEL SETTING CCT

2

Vcc

R

Ic

$S_{OECL}$

7  V2

3 TTL CCT

TTL OUTPUT

SIN

T2  T1

V1

V3

5

6

$I_{CNST}$

EP 0 349 824 A2

## FIG.2 *PRIOR ART*

## FIG.3

EP 0 349 824 A2

FIG.4

FIG.5

FIG.7

# FIG.6

EP 0 349 824 A2